Europäisches Patentamt

European Patent Office

Office européen des brevets

(19)

(11) Numéro de publication : **0 055 644**
**B1**

(12) **FASCICULE DE BREVET EUROPÉEN**

(45) Date de publication du fascicule du brevet :
05.06.85

(51) Int. Cl.⁴ : **H 01 L 29/78, H 01 L 27/06**

(21) Numéro de dépôt : **81401934.5**

(22) Date de dépôt : **04.12.81**

(54) **Transistor MOS à fonctionnement bipolaire en saturation.**

(30) Priorité : **29.12.80 FR 8027688**

(43) Date de publication de la demande :
**07.07.82 Bulletin 82/27**

(45) Mention de la délivrance du brevet :
**05.06.85 Bulletin 85/23**

(84) Etats contractants désignés :
**DE FR GB IT NL**

(56) Documents cités :
**EP-A- 0 020 978**
**DE-A- 2 654 677**
**FR-A- 2 422 258**
**US-A- 4 095 252**
**IEEE TRANSACTIONS ON ELECTRON DEVICES,**
**volume ED-27, Février 1980 NEW YORK (US) R.W.**
**COEN et al. "A high performance planar power**
**MOSFET", pages 340-343**

(73) Titulaire : **THOMSON-CSF**
**173, Boulevard Haussmann**
**F-75379 Paris Cedex 08 (FR)**

(72) Inventeur : **Rufray, Jean-Claude**
**THOMSON-CSF SCPI 173, bld Haussmann**
**F-75360 Paris Cedex 08 (FR)**
Inventeur : **Descamps, Bernard**
**THOMSON-CSF SCPI 173, bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

## Description

La présente invention concerne le domaine des transistors à effet de champ à grille isolée, que l'on appelera également ci-après selon l'usage transistors MOS, et plus particulièrement de tels transistors MOS dans lesquels une région de source d'un premier type de conductivité est entourée d'une région intermédiaire du deuxième type de conductivité elle-même entourée d'une région de drain du premier type de conductivité. Des exemples de tels transistors sont les transistors couramment appelés DMOS et VMOS.

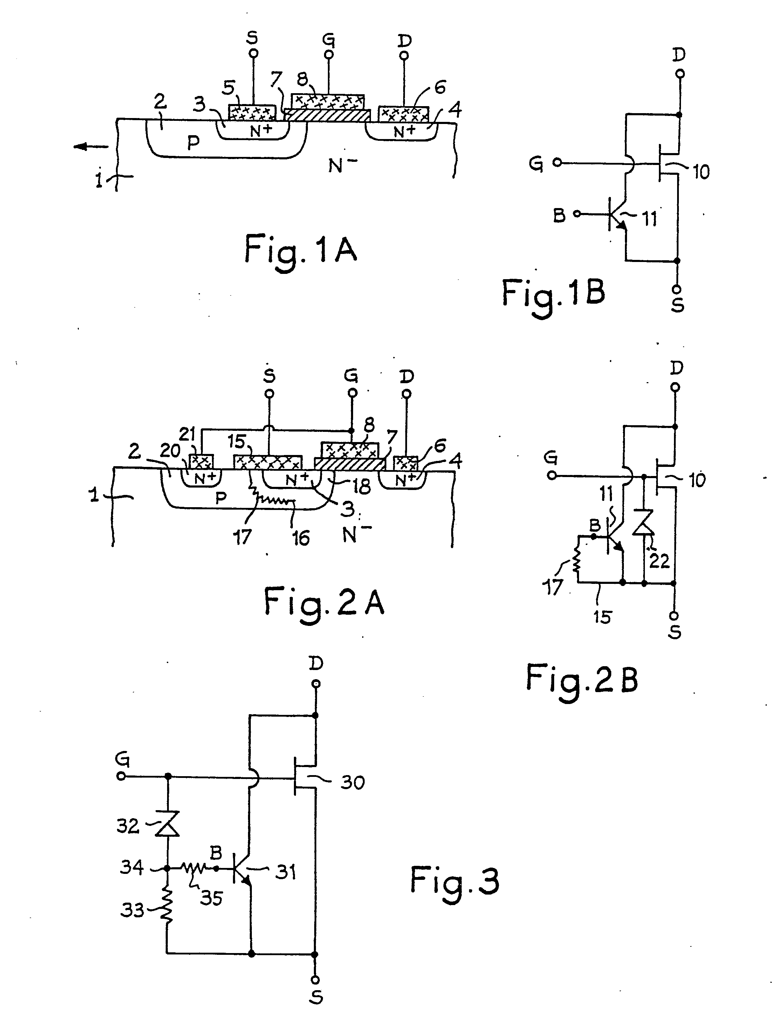

Les figures 1A et 1B représentent respectivement une vue en coupe schématique d'un transistor DMOS et son schéma équivalent. Comme le représente la figure 1A, un transistor DMOS est élaboré à partir d'une couche 1 de type N⁻, couramment formée par épitaxie sur un substrat N⁺. Dans cette couche est diffusée une zone 2 de type P qui sera appelée ci-après couche intermédiaire ou région intermédiaire. A l'intérieur et en dehors respectivement, de cette région 2 sont formées des régions de source et de drain de type N⁺ 3 et 4. Une métallisation de source 5 est formée sur la région de source 3 et est connectée à une borne de source S. Une métallisation de drain 6 est formée sur la région de drain 4 et est connectée à une borne de drain D. Une partie de la surface supérieure de la couche intermédiaire 2, en regard de la couche de drain 4 est revêtue d'une mince couche d'oxyde ou oxyde de grille 7 elle-même revêtue d'une métallisation de grille 8 connectée à une borne de grille G. On notera que couramment cette « métallisation » de grille peut être constituée de silicium polycristallin. Dans la figure 1A, la métallisation de grille a été représentée au-dessus de toute la région séparant la source du drain. En fait, la zone d'oxyde de grille et la métallisation de grille peuvent se limiter à la partie superficielle de la couche intermédiaire 2 dans laquelle on veut pouvoir créer un canal, sans s'étendre au-dessus de la partie superficielle de la couche 1. Bien entendu, la figure 1A est fortement schématique et en fait le dispositif comprend notamment, en plus des couches représentées, de nombreuses couches d'oxyde au-dessus de la surface, ces couches ayant servi de masque et passivant les jonctions.

La figure 1B représente un schéma équivalent de la structure de la figure 1A. On y retrouve les bornes G, S et D d'un transistor MOS principal 10. Mais, il faut noter qu'il existe également dans la structure de la figure 1A un transistor bipolaire parasite dont la couche d'émetteur correspond à la couche 3 de source, dont la couche de base correspond à la couche intermédiaire 2 et dont la couche de collecteur correspond aux couches de drain 1, 4. Ce transistor bipolaire 11 se trouve donc en parallèle sur le transistor à effet de champ 10, sa base B étant en l'air (non connectée). Un inconvénient bien connu de maintenir ainsi en l'air la base d'un transistor est que celui-ci peut se déclencher aléatoirement sur des parasites éventuels et notamment dans le cas où les diverses tensions appliquées au dispositif s'élèvent.

Ainsi, dans l'art antérieur, on a toujours considéré que ce transistor bipolaire 11 était un transistor parasite dont il fallait absolument éviter le déclenchement. Le même problème se pose d'ailleurs pour d'autres dispositifs MOS comprenant en parallèle un transistor bipolaire à gain non négligeable, par exemple pour les transistors MOS à rainures en V, couramment appelés VMOS.

La figure 2A dans laquelle de mêmes références désignent de mêmes éléments ou couches qu'en figure 1A, représente une vue en coupe d'un transistor DMOS classique comprenant deux modifications principales par rapport à la structure de base de la figure 1A.

La première modification introduite en figure 2A réside dans le fait que la métallisation de source 5 est remplacée par une métallisation de source 15 recouvrant d'une part la région de source 3, d'autre part la surface superficielle adjacente de la couche intermédiaire 2 en un emplacement éloigné de la zone dans laquelle se forme le canal. Ainsi, si l'on désigne par la référence 16 la zone de la région intermédiaire 2 qui correspond à la zone de base du transistor bipolaire 11, la métallisation permet d'établir un contact avec cette zone 16, ce contact étant faiblement résistif. Néanmoins, comme cela est connu, il existe quand même une faible résistance désignée par la référence 17 entre la métallisation 15 et la zone de base 16 pouvant entraîner un déclenchement parasite par avalanche du transistor bipolaire quand le courant et la tension source-drain deviennent importants. Pour minimiser cette résistance, on recourt à une couche intermédiaire de type P à niveau de dopage relativement élevé, par exemple de l'ordre de 10¹⁸ atomes par cm³, plus élevé que le niveau de dopage dans la zone 18 dans laquelle on veut former le canal qui doit être de l'ordre de 10¹⁶ à 10¹⁷ atomes/cm³ pour obtenir une commande satisfaisante à faible tension du transistor MOS par action sur sa grille. Ainsi, en recourant à l'ensemble de ces précautions, on peut considérer que, comme le représente la figure 2B, le transistor 11 a sa base reliée à son émetteur et est donc en permanence bloqué.

L'autre modification par rapport à la structure de la figure 1A réside dans la prévision d'une zone 20 de type N⁺ dans la région intermédiaire 2. Cette zone 20 est revêtue d'une métallisation 21 reliée à la grille G du transistor MOS. La zone 20 forme avec la région 2 une diode Zener et son utilité est d'éviter des claquages de la couche d'oxyde 7 au cas où la tension de grille monterait accidentellement à des valeurs trops élevées. Cette diode Zener de protection est illustrée en figure 2B sous la référence 22.

La présente invention se base sur une analyse de cette structure de l'art antérieur d'où il ressort que, selon un préjugé établi, le transistor bipolaire existant inévitablement en parallèle sur le transistor MOS était considéré comme un transistor parasite qu'il convenait de bloquer pour que le transistor MOS fonctionne seul. En effet, les avantages des transistors MOS par rapport aux transistors bipolaires sont notamment qu'ils présentent une haute impédance d'entrée, que leur tension de claquage entre drain et source est nettement plus élevée que la tension de claquage équivalente entre collecteur et émetteur d'un transistor bipolaire et qu'ils ne présentent pas le phénomène dit de second claquage. Par contre, les transistors bipolaires présentent par rapport aux transistors MOS l'avantage que leur tension de saturation est plus faible, c'est-à-dire que la chute de tension dans l'état passant est plus faible, d'autre part que la caractéristique du courant de drain ou de collecteur en fonction du courant de grille ou de base est plus raide dans le cas du transistor bipolaire qui peut laisser passer des courants plus intenses. Si l'on examine ces divers avantages et inconvénients des transistors bipolaires et des transistors MOS, on peut en conclure qu'au voisinage du régime bloqué tous les avantages sont au dispositif de type MOS (meilleure tenue en tension) et qu'en régime saturé tous les avantages sont aux transistors bipolaires (plus faible chute de tension en direct et courant passant pouvant être plus important). En d'autres termes, à l'état bloqué et à faible tension de commande, les avantages sont au dispositif MOS alors que pour des fortes tensions de commande, quand on se rapproche de l'état de saturation, les avantages sont au transistor bipolaire.

D'autre part, il est connu notamment d'après le brevet américain 4.095.252 et le brevet français 2.422.258 d'associer en parallèle des transistors à effet de champ avec des transistors bipolaires afin de cumuler leurs avantages respectifs.

Ainsi, le brevet américain 4.095.252 décrit l'association d'un transistor bipolaire et d'un transistor MOS à jonction donnant une structure composite ayant des caractéristiques de transfert du signal améliorées. De même, le brevet français 2.422.258 concerne un amplificateur de type Darlington réalisé à l'aide d'un transistor V.MOS et d'un transistor bipolaire pour éviter les inconvénients d'une réalisation uniquement avec deux transistors bipolaires ou uniquement avec deux transistors V.MOS.

Ainsi, un objet de la présente invention est de prévoir un circuit associant à un transitor à effet de champ à grille isolée un transistor bipolaire et fonctionnant comme un transistor à effet de champ à faible tension de commande et comme un transistor bipolaire à forte tension de commande.

Un autre objet de la présente invention est de prévoir un transitor à effet de champ à grille isolée pouvant fonctionner comme un transistor bipolaire à forte tension de commande.

Pour atteindre ces objets ainsi que d'autres, la présente invention prévoit un circuit associant un transistor à effet de champ à grille isolée à un transistor bipolaire, le drain étant connecté au collecteur et la source à l'émetteur, une borne de commande étant connectée à la grille, la base du transistor bipolaire étant connectée à la grille, la base du transistor bipolaire étant connectée d'une part à la grille du transistor MOS par l'intermédiaire d'un dispositif à seuil, par exemple une diode Zener, d'autre part à la connexion émetteur-source par l'intermédiaire d'une résistance de forte valeur.

Selon un autre de ses aspects, la présente invention prévoit un transistor MOS comprenant une région de source du premier type de conductivité entourée d'une région intermédiaire du deuxième type de conductivité, elle-même entourée d'une région de drain du premier type de conductivité, les parties de région intermédiaire situées entre les régions de source et de drain étant recouvertes d'une couche d'oxyde, elle-même revêtue d'une métallisation de grille, et une métallisation de source étant formée sur la surface de la région de source sans en déborder, cette structure étant ainsi associée à un transistor bipolaire parasite constitué desdites régions de source, intermédiaire et de drain. Selon un mode de réalisation de la présente invention, dans ce transistor, la zone de la région intermédiaire située en volume sous la région de source et formant la base du transistor parasite est reliée par l'intermédiaire d'un dispositif à seuil à la métallisation de grille et par l'intermédiaire d'une résistance de forte valeur à la métallisation de source ; la connexion avec ladite zone de la région intermédiaire située entre les régions de source et de drain est assurée par une métallisation sur la zone intermédiaire proche d'une frontière de la région de source mais distincte de celle-ci. Selon un autre mode de réalisation de la présente invention, le dispositif à seuil est réalisé par une zone du premier type de conductivité formée dans la couche intermédiaire, cette zone étant reliée à la métallisation de grille, et la résistance de forte valeur est réalisée par une métallisation supplémentaire disposée sur une portion de la région intermédiaire en un emplacement plus éloigné de la frontière de la zone de source que ladite zone du premier type de conductivité, cette métallisation supplémentaire étant reliée à la métallisation de source.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A et 2A représentent des vues en coupe de structures de transistors DMOS de l'art antérieur ;

les figures 1B et 2B représentent des schémas équivalents aux dispositifs des figures 1A et 2A ;

la figure 3 représente le schéma électrique d'un circuit selon la présente invention ;

la figure 4 représente une vue en coupe d'un transistor DMOS selon la présente invention ;

la figure 5 représente une vue de dessus d'un transistor DMOS selon la présente invention ;

la figure 6 représente une vue en coupe d'un transistor VMOS selon la présente invention ;

les figures 7 et 8 représentent respectivement une vue en coupe et une vue de dessus d'un transistor DMOS faisant partie d'un circuit selon la présente invention :

les figures 9 et 10 représentent des caractéristiques d'un circuit selon la présente invention.

Conformément à l'usage dans le domaine de la représentation des semiconducteurs, les diverses figures sont fortement schématiques et les épaisseurs et dimensions des couches ne sont pas tracées à l'échelle ni d'une figure à l'autre, ni à l'intérieur d'une même figure. D'autre part, ces figures ont été fortement simplifiées pour ne montrer que les éléments les plus utiles à l'exposé des caractéristiques essentielles de l'invention.

La figure 3 représente le circuit électrique selon l'invention. Ce circuit comprend un transistor MOS 30 en parallèle avec un transistor bipolaire 31. Le drain du transistor MOS est connecté au collecteur du transistor bipolaire et à une borne principale qui sera appelée D. La source du transistor MOS 30 est connectée à l'émetteur du transistor bipolaire et à une borne principale qui sera appelée S. La grille du transistor MOS est connectée à une borne de commande qui sera appelée G. La base du transistor bipolaire 31 est connectée d'une part à la borne G par l'intermédiaire d'un dispositif à seuil tel qu'une diode Zener 32 d'autre part à la borne S par l'intermédiaire d'une résistance de forte valeur 33. On désignera par la référence B la base réelle du transistor 31 et par la référence 34 le point de connexion entre le dispositif à seuil 32 et la résistance 33. En effet, on verra, que dans des modes de réalisation pratiques sous forme intégrée, il existera éventuellement des résistances de faible valeur entre ce point de connexion 34, et le dispositif à seuil 32 d'une part et la borne B d'autre part. Néanmoins, ces résistances seront de valeurs négligeables devant celle de la résistance 33.

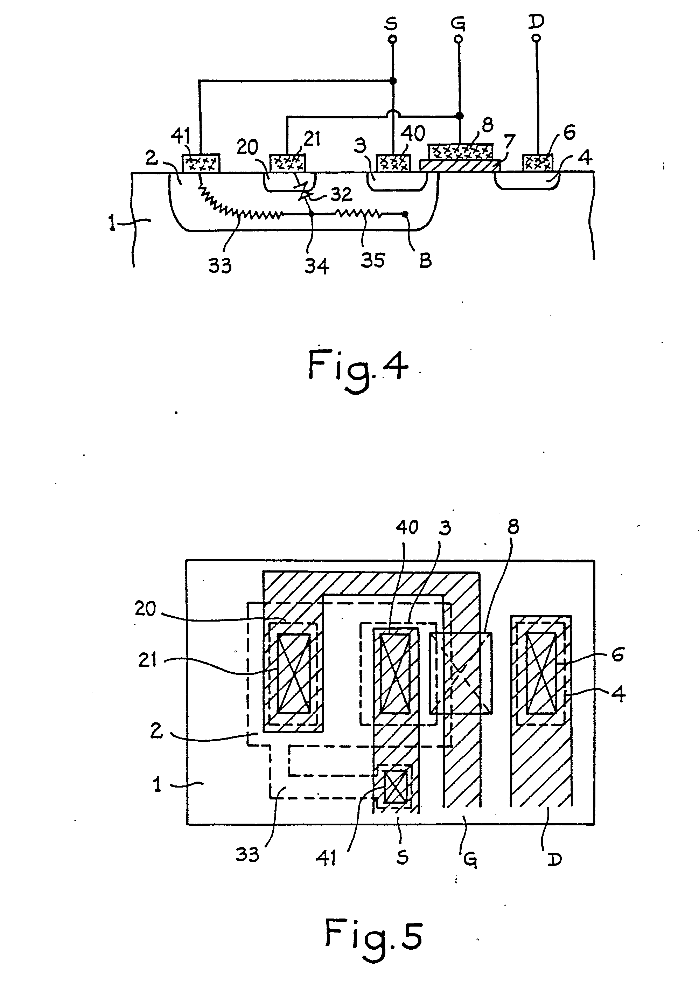

La figure 4 représente un transistor DMOS mettant en œuvre la présente invention. Dans cette figure 4, de mêmes références ont été utilisées pour définir de mêmes parties qu'en figure 1A et 2A. On retrouve la couche 1 à faible niveau de dopage de type N, la couche intermédiaire 2, la région de source 3, la région de drain 4, la métallisation de drain 6, la couche d'oxyde de grille 7, la métallisation de grille 8, la couche d'oxyde de grille 7, la métallisation de grille 8, la couche de type N$^+$ 20 et la métallisation correspondante 21 reliée à la borne de grille G. En outre, il est prévu une métallisation de source 40 analogue à la métallisation 5 de la figure 1A, reposant uniquement sur une partie de la région de source 3. Cette métallisation de source 40 est reliée à une métallisation supplémentaire 41 reposant sur la couche intermédiaire 2. Cette métallisation supplémentaire est suffisamment éloignée de la zone de base B située en dessous de la région 3 pour qu'une résistance importante 33 se présente entre la métallisation 41 et cette zone de base B. D'autre part, la jonction entre la zone 20 et la couche intermédiaire 2 correspond à une diode Zener 32 constituant un mode de réalisation du dispositif à seuil illustré en figure 3. Les positionnements relatifs des diverses couches et zones (contrairement à ce qui est en fait représenté sur la figure 4) sont choisis pour que la résistance 35 existant dans la couche intermédiaire 2 entre la jonction Zener 32 et la zone de base réelle B soit faible devant la résistance 33 qui doit avoir une valeur nettement supérieure à un kilohm, et de préférence à quelques dizaines de kilohms.

La figure 5 représente une vue de dessus d'un transistor DMOS selon l'invention tel que celui de la figure 4 représenté de façon un peu plus réaliste bien que les dimensions relatives des divers éléments soient encore éloignées de la réalité pratique comme le notera aisément l'homme de l'art. Cette figure 5 sera considérée comme faisant partie intégrante de la présente invention. De mêmes références sont utilisées pour désigner des portions analogues à celles de la figure 4. Les métallisations sont représentées de façon hachurée, les limites des zones de diffusion par des pointillés, les zones de contact entre les métallisations et les couches sous-jacentes par des rectangles barrés d'une croix, la métallisation de grille étant figurée par un rectangle barré d'une croix en pointillés. Pour cette dernière métallisation, on notera que, de façon classique, elle ne s'étend pas de la grille au drain, mais essentiellement au-dessus de la partie de la zone intermédiaire dans laquelle se forme le canal. La métallisation 41 est placée sur une portion de la couche intermédiaire 2 formant un prolongement en forme de doigt par rapport à la partie principale de cette couche intermédiaire. Ce prolongement est désigné par la référence 33 en figure 5 étant donné qu'il correspond très exactement à la résistance 33 de la figure 3.

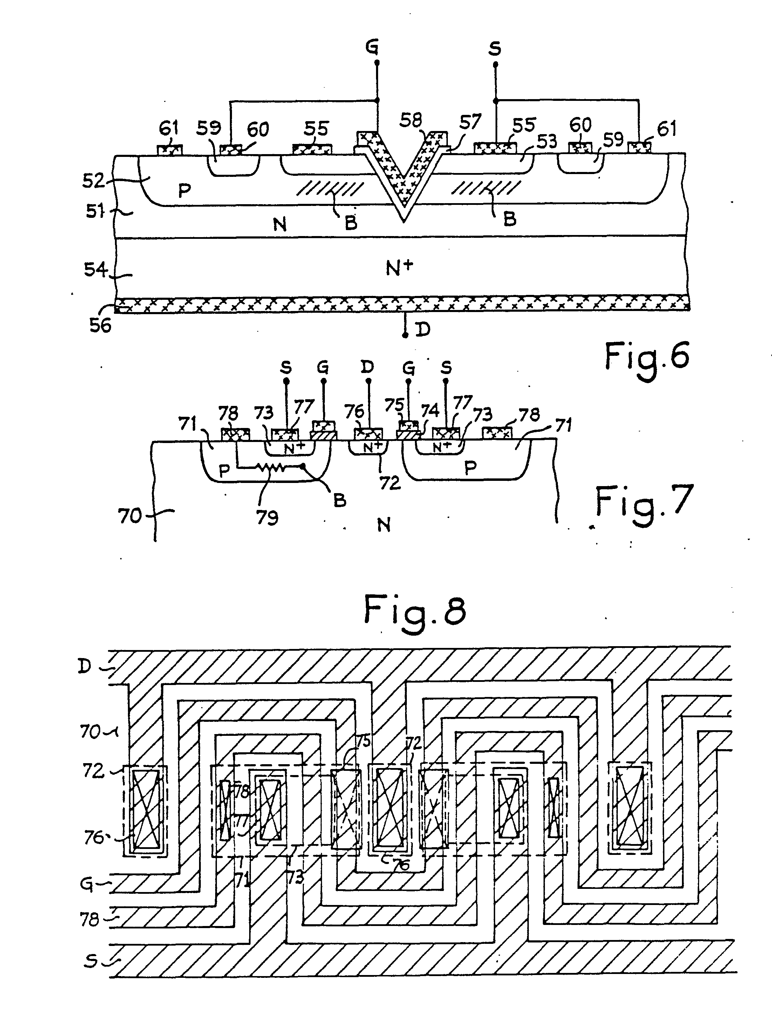

La figure 6 représente un circuit selon la présente invention réalisé à partir d'une structure de transistor de type VMOS. Ce transistor comprend une couche 51 de type N à faible niveau de dopage dans laquelle est formée une couche intermédiaire 52 de type P. Dans cette couche intermédiaire est diffusée une région de source de type N$^+$ 53. L'autre face de la couche 51 est solidaire d'une couche de type N à fort niveau de dopage 54, sur laquelle, de façon classique, elle a été formée par épitaxie. Une métallisation de source 55 repose sur la région de source 53 et une métallisation de drain 56 repose sur la région de drain 54. Une rainure en V traverse les couches 53 et 52 pour atteindre la couche 51. Cette rainure est recouverte d'une couche d'oxyde de grille 57, elle-même revêtue d'une métallisation de grille 58 (couramment du silicium polycristallin). Une autre diffusion de type N$^+$ 59 analogue à la région 20 de la figure 4 est formée dans la région intermédiaire 52 et est reliée par une métallisation 60 à la borne de grille G. Un contact supplémentaire 61 est formé sur la couche de type P, suffisament loin de la région de base B, figurée par des hachures, pour qu'il existe une résistance 33 importante entre cette métallisation 61 et cette région de base B. Ainsi, le schéma de la figure 6 réalise une structure analogue à celle du circuit de la figure 3, mais dans une technologie VMOS plutôt que dans une technologie DMOS comme c'était le cas pour la figure 4. Bien entendu, on notera que, de même que la métallisation 41 en figure 4, la métallisation 61 en figure 6 est représentée trop proche de la région de diode Zener et de la région de base pour que le dispositif puisse fonctionner de façon satisfaisante. Il conviendra que cette métallisation 61 soit éloignée par un processus du même type que celui illustré dans la vue de dessus de la figure 5 pour que le dispositif puisse fonctionner, par exemple en étant placée sur un prolongement digité de la région 52.

Les figures 7 et 8 représentent respectivement et de façon très schématique une vue en coupe et une vue de dessus d'un transistor DMOS de puissance appelé à faire partie d'un circuit selon la présente invention. Si l'on se réfère à la figure 3, les figures 7 et 8 illustrent le cas d'une variante dans laquelle, à l'intérieur d'un transistor MOS, on se réserve un accès à la base B (ou au point 34) tandis que le dispositif à seuil 32 et la résistance 33 sont formés dans une autre portion du circuit intégré ou même à l'extérieur du circuit intégré. Cette variante aurait pu être illustrée en relation avec un dispositif de type DMOS tel que celui de la figure 4 ou d'un dispositif de type VMOS tel que celui de la figure 6. Néanmoins, on a préféré pour bien montrer que la présente invention n'est pas limitée à un mode de réalisation particulier illustrer cette variante en relation avec un autre type de transistor DMOS.

Le transistor DMOS de la figure 7 comprend une couche 70 de type N sur laquelle sont réalisées des diffusions de régions P intermédiaires 71 symétriques. Entre ces régions 71 est formée une diffusion 72 de type $N^+$ correspondant au drain. Symétriquement par rapport à ce drain, sont réalisées à l'intérieur des couches intermédiaires 71 des diffusions de source 73 de type $N^+$. Les parties de zone intermédiaire 71 situées entre les régions de source 73 et les régions de drain 72 sont recouvertes d'une couche d'oxyde 74 elle-même revêtue d'une métallisation de grille 75. Une métallisation de drain 76 repose sur la région 72 et une métallisation de source 77 repose sur la région 73 sans en déborder. Jusque-là, on a décrit une structure de DMOS existant de façon classique. On notera d'ailleurs que, dans une variante de cette structure, il n'existe pas de région 72 entre les régions 71, mais la métallisation de drain est réalisée sur l'autre face de la couche 70 et on obtient ainsi un transistor DMOS à fonctionnement vertical. Selon la présente invention, il est prévu sur la couche intermédiaire 71 dans une portion éloignée de celle sur laquelle est formée la grille une métallisation supplémentaire 78 proche de la région de source 73. Ainsi, cette métallisation 78 permet d'établir un contact avec la zone de base B située sous la région de source 73 par l'intermédiaire d'une résistance de faible valeur 79. Ensuite, cette métallisation 78, qui correspond à la borne 34 de la figure 3, est reliée à l'extérieur de la structure MOS à un dispositif à seuil connecté à la borne G et à une résistance de forte valeur connectée à la borne S. Ceci permet de réaliser des dispositifs à seuil plus élaborés qu'une simple diode Zener ou bien de réaliser une diode Zener à seuil mieux défini que si elle se trouvait au milieu du transistor DMOS dans lequel les niveaux de dopage des diverses couches sont plus ou moins prédéterminés. En outre, ceci permet également de choisir plus précisément la résistance 33 de forte valeur.

La figure 8 représente à titre d'exemple une vue de dessus correspondant à la vue en coupe de la figure 7. Cette figure ne sera pas décrite en détail. De mêmes éléments qu'en figure 7 y sont représentés par de mêmes références. En outre, le symbolisme précédemment exposé en relation avec la figure 5 a été utilisé.

Dans ce qui précède, on notera que la prévision de la métallisation supplémentaire au contact avec la couche intermédiaire de type P peut être faite par tout moyen technologique connu pour assurer un contact ohmique convenable. Par exemple, cette métallisation peut consister en une couche de silicium polycristallin fortement dopée de type P à partir de laquelle on peut obtenir un surdosage localisé de la couche de type P.

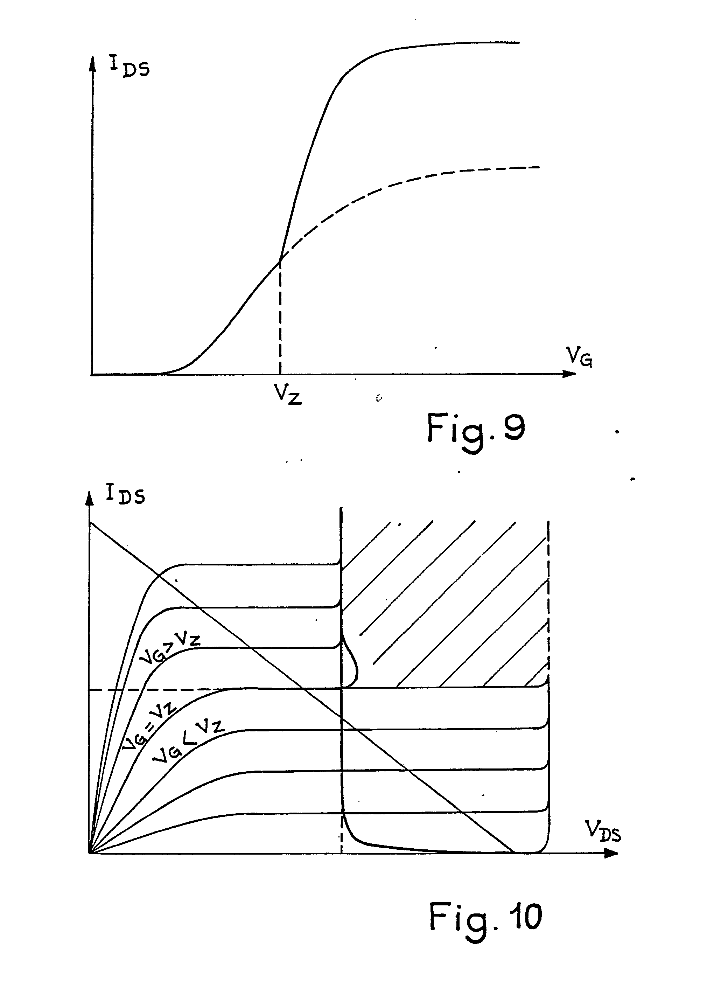

Les figures 9 et 10 illustrent des courbes caractéristiques permettant de mieux faire ressortir les avantages de la présente invention.

La figure 9 illustre la caractéristique du courant principal $I_{DS}$ entre les bornes principales D et S du dispositif selon la présente invention en fonction de la tension $V_G$ appliquée sur la borne de commande. On voit que, quand on atteint la tension $V_Z$ correspondant au seuil de la diode Zener, la pente de la caractéristique change. En effet, on passe d'une caractéristique classique d'un transistor DMOS à une caractéristique de transistor bipolaire. En outre, on voit que le courant de saturation pour le dispositif, qui correspond au courant de saturation du transistor bipolaire, est plus élevé que ne le serait le courant de saturation du transistor DMOS indiqué par la continuation de courbe en pointillés.

La figure 10 représente un réseau de courbes indiquant l'intensité $I_{DS}$ entre les bornes D et S en fonction de la tension $V_{DS}$ entre ces bornes D et S pour diverses valeurs de la tension $V_G$ appliquée à la borne de commande. Notamment, on a indiqué les cas pour lesquels la tension de commande $V_G$ était inférieure à la tension de la diode Zener, égale à cette tension, ou supérieure à cette tension. La courbe en trait gras désignée par la référence 80 indique la limite d'utilisation normale pour le transistor bipolaire s'il fonctionnait seul. Ainsi, on voit que, pour de faibles valeurs du courant drain-source et pour de faibles valeurs de la tension de grille, du fait du fonctionnement en transistor MOS le dispositif peut supporter des tensions drain-source plus élevées. On voit également à la partie supérieure gauche de la figure que, du fait du fonctionnement en transistor bipolaire, on peut atteindre des courants drain-source plus intenses. Le dispositif selon l'invention permet donc bien comme cela a été annoncé dans la partie introductrice de la présente demande d'obtenir de façon cumulée les avantages du fonctionnement en transistor MOS pour de faibles tensions de grille et du fonctionnement en transistor bipolaire pour de fortes tensions de grille.

Un autre avantage du dispositif selon la présente invention par rapport aux transistors MOS classiques est que, comme on l'a exposé précédemment en relation avec la figure 2A, on était amené dans l'art antérieur à utiliser des zones intermédiaires 2 relativement fortement dopées et à choisir un niveau de dopage différent pour la zone 18 dans laquelle est susceptible de se former le canal sous l'influence de la tension appliquée à la grille. Avec la présente invention, ceci n'est plus nécessaire et on peut utiliser sans inconvénient une zone intermédiaire uniformément dopée à la valeur choisie pour obtenir un dopage satisfaisant dans la zone dans laquelle est susceptible de se former le canal. Il en résulte une fabrication simplifiée du transistor MOS.

La présente invention n'est pas limitée aux modes de réalisation qui ont été explicitement décrits. Elle en englobe les diverses variantes et généralisations incluses dans le domaine des revendications ci-après.

## Revendications

1. Circuit associant un transistor à effet de champ à grille isolée (30) à un transistor bipolaire (31), le drain étant connecté au collecteur et la source à l'émetteur, une borne de commande (G) étant connectée à la grille, caractérisé en ce que la base (B) du transistor bipolaire est connectée d'une part à la grille (G) du transistor à effet de champ par l'intermédiaire d'un dispositif à seuil (32) d'autre part à la connexion émetteur-source (S) par l'intermédiaire d'une résistance de forte valeur (33), d'où il résulte que le circuit fonctionne comme un transistor à effet de champ pour de faibles tensions de commande et comme un transistor bipolaire pour des tensions de commande plus élevées que le seuil du dispositif à seuil.

2. Transistor à effet de champ à grille isolée comprenant une région de source (73) d'un premier type de conductivité entourée d'une région intermédiaire (71) du deuxième type de conductivité elle-même entourée d'une région de drain (70) du premier type de conductivité, les parties de région intermédiaire (71) situées entre les régions de source et les régions de drain étant recouvertes d'une couche d'oxyde (74), elle-même revêtue d'une métallisation de grille (75) et une métallisation de source (77) étant formée sur la surface de la région de source sans en déborder, cette structure étant ainsi associée à un transistor bipolaire parasite constitué desdites régions de source (73), intermédiaire (71) et de drain (70) caractérisé en ce que la zone (B) de la région intermédiaire situé en volume sous la région de source et formant la base dudit transistor parasite est reliée par l'intermédiaire d'un dispositif à seuil á la métallisation de grille et par l'intermédiaire d'une résistance de forte valeur à la métallisation de source.

3. Transistor à effet de champ selon la revendication 2, caractérisé en ce que la connexion avec ladite zone de la région intermédiaire est assurée par la métallisation (78) sur la zone intermédiaire proche d'une frontière de la région de source mais distincte de celle-ci et éloignée de la zone superficielle intermédiaire entre les régions de source et de drain.

4. Transistor à effet de champ selon la revendication 2, caractérisé en ce que le dispositif à seuil est réalisé par une zone du premier type de conductivité (20, 59) formée dans la région intermédiaire, cette zone étant reliée à la métallisation de grille et en ce que la résistance de forte valeur est réalisée par une métallisation supplémentaire (41, 61) disposée sur une portion de la région intermédiaire en un emplacement plus éloigné de la zone source que ladite zone du premier type de conductivité, cette métallisation supplémentaire étant reliée à la métallisation de source (40, 55).

5. Transistor à effet de champ selon la revendication 4, caractérisé en ce que la métallisation supplémentaire est réalisée sur une portion de la région intermédiaire prolongeant à la façon d'un doigt la partie principale de cette région intermédiaire.

6. Transistor à effet de champ selon la revendication 4, caractérisé en ce qu'il est de type DMOS.

7. Transistor à effet de champ selon la revendication 4, caractérisé en ce qu'il est de type VMOS.

## Claims

1. Circuit associating an insulated gate field-effect transistor (30) with a bipolar transistor (31), the drain being connected to the collector and the source to the emitter, a control terminal (G) being connected to the gate, characterized in that the base (B) of the bipolar transistor is connected on the one hand to the gate (G) of the field-effect transistor via a threshold device (32) and on the other hand to the connection between emitter and source (S) via a resistor (33) of high value, as a result of which the circuit functions like a field-effect transistor for low control voltages and like a bipolar transistor for control voltages higher than the threshold value of the threshold device.

2. Insulated gate field-effect transistor comprising a source region (73) of a first conductivity type surrounded by an intermediate region (71) of the second conductivity type which in turn is surrounded by a drain region (70) of the first conductivity type, the portions of the intermediate region (71) situated between the source regions and the drain regions being covered by an oxide layer (74) itself covered by a gate metallization (75) and a source metallization (77) being formed on the surface of the source region without projecting therebeyond, this structure being associated with a parasitic bipolar transistor constituted by said source region (73), intermediate (71) and drain regions (70), characterized in that the zone (B) of the intermediate region situated in volume beneath the source region and forming the base of the parasitic transistor is connected via a threshold device to the gate metallization and via a resistor of high value to the source metallization.

3. Field-effect transistor according to claim 2, characterized in that the connection to said zone of the intermediate region is insured by the metallization (78) on the intermediate zone close to a boundary of the source region but distinct from the latter and remote from the surface zone intermediate between the source region and the drain region.

4. Field-effect transistor according to claim 2, characterized in that the threshold device is formed by a zone of the first conductivity type (20, 59) formed in the intermediate region, said zone being connected to the gate metallization, and in that the resistor of high value is formed by an additional metallization (41, 61) disposed on a portion of the intermediate region at a location remoter from the source zone than said zone of the first conductivity type, said additional metallization being connected to the source metallization (40, 55).

5. Field-effect transistor according to claim 4, characterized in that the additional metallization is formed on a portion of the intermediate region extending in finger manner the main portion of said intermediate region.

6. Field-effect transistor according to claim 4, characterized in that it is of DMOS type.

7. Field-effect transistor according to claim 4, characterized in that it is of VMOS type.

**Patentansprüche**

1. Schaltung, bei welcher ein Feldeffekttransistor mit isoliertem Gate (30) einem bipolaren Transistor (31) zugeordnet ist, wobei der Drain mit dem Kollektor und die Source mit dem Emitter verbunden ist, wobei ferner ein Steueranschluß (G) mit dem Gate verbunden ist, dadurch gekennzeichnet, daß die Basis (B) des bipolaren Transistors einerseits über eine Schwellwertvorrichtung (32) mit dem Gate (G) des Feldeffekttransistors und andererseits mit der Verbindung zwischen Emitter und Source (S) über einen Widerstand (33) von großem Wert verbunden ist, woraus sich ergibt, daß die Schaltung für geringe Steuerspannungen als Feldeffekttransistor und für höhere Steuerspannungen als der Schwellwert der Schwellwertvorrichtung als bipolarer Transistor wirkt.

2. Feldeffekttransistor mit isoliertem Gate, welcher ein Sourcegebiet (73) eines ersten Leitungstyps enthält, das von einem Zwischengebiet (71) des zweiten Leitungstyps umgeben ist, das seinerseits von einem Draingebiet (70) des ersten Leitungstyps umgeben ist, wobei die Zwischengebietteile (71), welche zwischen den Sourcegebieten und den Draingebieten liegen, von einer Oxidschicht (74) bedeckt sind, die ihrerseits durch eine Gatemetallisierung (75) bedeckt ist, wobei eine Sourcemetallisierung (77) auf der Oberfläche des Sourcegebietes gebildet isr, ohne darüber hinauszustehen, und wobei dieser Struktur so ein parasitärer bipolarer Transistor zugeordnet ist, der aus dem genannten Sourcegebiet (73), dem genannten Zwischengebiet (71) und dem genannten Draingebiet (70) gebildet ist, dadurch gekennzeichnet, daß die Zone (B) des Zwischengebietes, welche im Volumen unter dem Sourcegebiet liegt und die Basis des parasitären Transistors bildet, über eine Schwellwertvorrichtung mit der Gatemetallisierung und über einen Widerstand von hohem Wert mit der Sourcemetallisierung verbunden ist.

3. Feldeffektransistor nach Anspruch 2, dadurch gekennzeichnet, daß die Verbindung mit der genannten Zone des Zwischengebietes durch die Metallisierung (78) auf der Zwischenzone gewährleistet ist, welche nahe an einer Grenze des Sourcegebietes liegt, jedoch von dieser getrennt und von der Oberflächenzone zwischen dem Sourcegebiet und dem Draingebiet entfernt ist.

4. Feldeffekttransistor nach Anspruch 2, dadurch gekennzeichnet, daß die Schwellwertvorrichtung durch eine Zone des ersten Leitungstyps (20, 59) gebildet ist, welche in dem Zwischengebiet gebildet ist, wobei diese Zone mit der Gatemetallisierung verbunden ist, und daß der Widerstand von hohem Wert durch eine zusätzliche Metallisierung (41, 61) gebildet ist, die auf einem Teil des Zwischengebietes an einer Stelle angeordnet ist, welche von der Sourcezone weiter entfernt ist als die genannte Zone des ersten Leitungstyps, wobei diese zusätzliche Metallisierung mit der Sourcemetallisierung (40, 55) verbunden ist.

5. Feldeffekttransistor nach Anspruch 4, dadurch gekennzeichnet, daß die zusätzliche Metallisierung auf einem Teil des Zwischengebietes gebildet ist, der den Hauptteil dieses Zwischengebietes fingerförmig verlängert.

6. Feldeffekttransistor nach Anspruch 4, dadurch gekennzeichnet, daß es ein DMOS-Typ ist.

7. Feldeffekttransistor nach Anspruch 4, dadurch gekennzeichnet, daß es ein VMOS-Typ ist.

Fig.1A

Fig.1B

Fig.2A

Fig.2B

Fig.3

1

Fig.4

Fig.5

Fig.6

Fig.7

Fig.8

Fig. 9

Fig. 10